# EUROPEAN PATENT APPLICATION

(11) **EP 2 239 781 A1**
(43) Date of publication of application: **13.10.2010**
(21) Application number: 09157421.0
(22) Date of filing: 06.04.2009
(51) Int. Cl.: H01L 29/66, H01L 29/08

(54) **Variable barrier tunnel transistor**

(71) Applicant: University College Cork-National University of Ireland, Cork, Cork (IE)
(72) Inventor: Afzalian, Aryan, Douglas Cork City (IE); Colinge, Jean- Pierre, Cork City (IE)
(74) Representative: Lucey, Michael

(57) **Abstract**

The present invention provides a transistor adapted to provide at least one tunnel barrier, with a variable shape and controlled by an electrode, such that current flow in the transistor is minimised when the transistor is turned off and the current is maximized when the transistor is turned on. The transistor device can comprise one or more variable tunnel barrier(s). The barrier(s) varies in such a way that the transparency of the barrier is changed in a range of energies relevant to the current transport when a voltage is applied to an electrode of the device, for example the gate electrode.

## Description

### Field of the Invention

The present invention relates to transistors. In particular the invention relates to a Variable Barrier Tunnel (VBT) transistor architecture and method.

### Background to the Invention

In a continuous effort to increase the performance of integrated circuits, the dimensions of semiconductor devices are continuously shrunk. This geometrical scaling goes in parallel with a scaling of the supply voltage. The semiconductor industry maintains a "roadmap", the ITRS, describing forecasts and technology barriers to development for device sizes updated approximately annually. The roadmap for such voltage supply has seen a steady reduction from 9V to 5V to 3.3V and now to 1.1V. The next step on this roadmap is 0.7V.

It is desirable to use a lower voltage supply in industry as this means lower power consumption in transistor devices and also limits the maximum value of the electric field below critical values in the transistors. However, the effectiveness to switch a transistor from its 'on' state to its 'off' state depends of the slope of the Id-Vg curve in subthreshold regime. The subthreshold slope of a classical transistor has a theoretical best value limit, which limits the efficiency with which it is possible to switch the transistor from off to on by applying a gate voltage. As the supply voltage, and therefore the gate voltage swing, is reducing drastically, this means that the on-to-off current ratio become lower and lower. To keep short-channel effects that degrade the subthreshold slope under control, silicon-on-insulator MOS transistors have evolved from classical, planar, single-gate devices into three-dimensional devices with a multigate structure. This makes it possible to keep subthreshold slope near its ideal value, i.e.60 mV/decade at room temperature.

However, with the further downscaling of Vdd, even an ideal subthreshold slope will not be enough to keep the off current and thus the power consumption low enough for future technology nodes and a new transistor who could switch off faster with Vg, i.e. have a lower subthreshold slope than the theoretical limit of 60 mV/decade at T=300K is highly desirable.

To understand the principle of operation of the VBT transistor and how it can be used to outperform the classical transistor structure, it is necessary to describe some fundamental concepts of the classical transistor.

In a classical transistor, the occupation of states by electrons in the conduction band follows a Fermi-Dirac distribution. Below the Fermi level, E_{F}, these states are filled and there are plenty of electrons. For Energy E above E_{F}, the occupancy of these states decreases exponentially as e^{-(E-E}_{F}^{)/k.T}, as shown in a publication by S.M. Sze, "The Physics of Semiconductor Devices", New York: Wiley, 1981. As a result the electron concentration in the conduction band increases exponentially with the difference in energy between the conduction band and the Fermi level (an n-channel is considered here, but similar considerations can be applied to a p-channel device where current transport is achieved by holes in the valence band instead of electrons in the conduction band, as is familiar to anyone skilled in the art). This brings about an increase of current that is, at best, exponentially dependent on gate voltage, with an activation energy equal to kT/q. When plotted on a semilogarithmic plot with a log base 10 axis for the current, the subthreshold current is a linear, straight line function of gate voltage with a slope at best equal to kT/q*ln(10) (units: V/decade) where In(10) is the natural logarithm of number ten and is equal to 2.3026. This slope is called "subthreshold slope" or "inverse subthreshold slope" or "subthreshold swing".

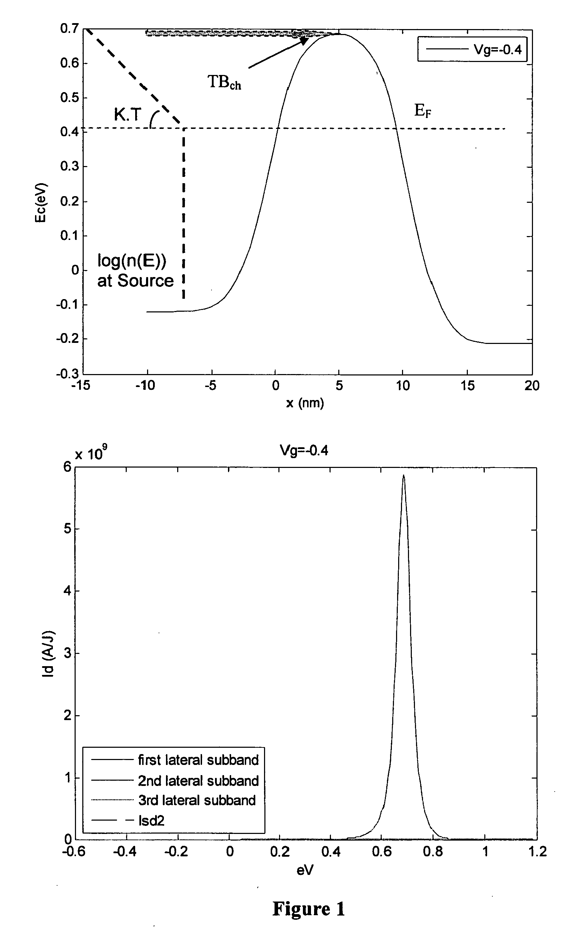

In a classical MOS transistor below threshold, the top of the energy barrier(s) in the channel, TB_{ch}, are above E_{F}, for example a nanowire transistor where energy subbands are formed within the conduction band, as shown in Figure 1. There are therefore only the few electrons that have their energy above TB_{ch} that can flow from the source to the drain of the transistor and participate to the current. Figure 1 shows the 1^{st} energy sub-band along the transport direction (left) and spectrum of the current vs. energy in the nanowire in sub-threshold regime at Vg=-0.4V. TB_{ch}, and therefore, the energy at which the current density peaks, is approximately equal to 0.65eV, which is above E_{F}.

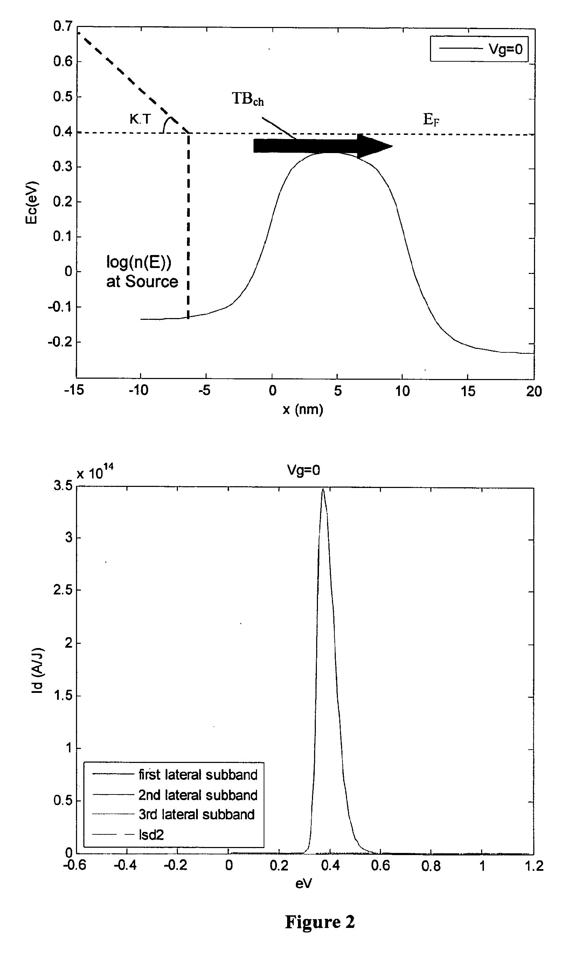

By increasing the gate voltage, however, TB_{ch} is reduced. With an ideal electrostatic control of the channel barrier by the gate (body factor=1), TB_{ch} will decrease by q.ΔV_{g} if the gate voltage is increased by ΔV_{g}. This allows for electrons with lower energy to participate to the current flow. The electron concentration increases exponentially with the gate voltage, which yields an exponential increase of current with gate voltage in the subthreshold region. The theoretical best (i.e. lowest) value limit of the subthreshold slope is 59.6 mV/decade at T=300K or, in general, kT/q log(10) at any temperature, T. Above threshold, the top of the energy barrier(s) in the channel, TB_{ch}, is below E_{F}. There are, therefore, plenty of electrons that have their energy above TB_{ch} and can flow from the source to the drain of the transistor, as shown in Figure 2. Figure 2 illustrates the 1^{st} energy subband along the transport direction (left) and Spectrum of the current vs. energy in the nanowire in subthreshold regime at Vg=0V. TB_{ch} is a little above 0.3eV, which is below E_{F}. This leads to a broad spectrum of the current density between TB_{ch} and E_{F}. By increasing the gate voltage, TB_{ch} is further reduced and therefore the number of electrons that have an energy above the channel barrier increases. When above threshold, the increase of current with gate voltage is no longer exponential, but is rather linear.

All the proposed tunnel devices to date are based on either a reverse PN junction (PN Tunnel junction, also known as Tunnel Diode or Esaki junction or Esaki diode - 1973 Nobel prize) or the formation of tunnel barriers using heterojunctions. All the proposed devices use tunnelling of electrons from the valence band into the conduction band (band-to-band tunnelling). Devices based on an Esaki junction are non symmetrical (there is an anode and a cathode, unlike regular MOS transistors which have a source and a drain). The formation of a heterojunction requires them either to have a vertical or non-planar transistor.

The reduction of power consumption in integrated circuits requires transistors that can operate at lower voltages. This requires devices that have a lower subthreshold slope, in order to overcome the above mentioned problems.

### Summary of the Invention

According to the invention there is provided, as set out of the appended claims, a transistor adapted to provide at least one tunnel barrier, with a variable shape and controlled by an electrode, such that current flow in the transistor is minimised when the transistor is turned off and the current is maximized when the transistor is turned on.

The transistor device can comprise one or more variable tunnel barrier(s). The barrier(s) varies in such a way that the transparency of the barrier is changed in a range of energies relevant to the current transport (from the minimum of the conduction band to a few tens of kT/q above the Fermi level for an N-channel transistor) when a voltage is applied to an electrode of the device, for example the gate electrode. The transparency of the barrier can be defined as the material property of allowing electrons to pass through.

If, when the gate voltage is increased, for example in the case of an N-channel transistor, while the device is in the subthreshold regime, the transparency of the barrier, Tr, is increased by reducing the height and/or width and/or by modifying the shape of the barrier, the on-to-off current ratio of the transistor will be improved and the subthreshold slope can be decreased to values below kT/q*log(10). It will be appreciated that by simultaneously reducing the height and width of the barrier can improve the transparency of the transistor, thus improving the operation of the transistor.

If the transparency of the tunnel barrier is increased continuously with Vg, it is possible to obtain a progressive transition between an off current that is reduced by a tunnel barrier to an on current that is not hampered by a barrier and the stronger the increase in transparency, the steepest the slope. If the transparency of the tunnel barrier is increased abruptly with Vg, an oscillation in the current is observed. The stronger the increase in transparency obtained, the larger the oscillation.

By reversing the principle of the invention, i.e. decreasing the transparency with Vg, it is possible to decrease the current while increasing Vg and/or provide regions with a negative transconductance. This is useful for oscillator and some memory devices.

In one embodiment if the transparency of the barrier decreases with gate voltage, the gate voltage will cause the current to oscillate to provide a region of negative transconductance.

In one embodiment the tunnelling is from conduction band to the conduction band on the other side of the tunnel barrier to provide intraband tunnelling.

In one embodiment the variable tunnel barrier is provided by a grain boundary in the transistor.

In one embodiment the variable tunnel barrier is provided by a constriction of the semiconductor.

In one embodiment the variable tunnel barrier is provided by an electrically charged sheet of material in the semiconductor.

In one embodiment the variable tunnel barrier is provided by a localized surface charge.

In one embodiment the variable tunnel barrier is provided by a local variation of the semiconductor material.

In one embodiment the variable tunnel barrier is provided by a local variation of the cross section or surface state.

In one embodiment the variable tunnel barrier is provided by a PN junction.

In one embodiment the variable tunnel barrier is provided by a Schottky junction.

In one embodiment the variable tunnel barrier is controlled by an independent electrode.

In one embodiment local defects in the crystalline structure of the transistor creates a local surface density of negative charges and an electrostatic barrier that curves the current profile of the transistor upwards.

In one embodiment the transistor comprises any kind of planar or non planar transistor structure.

In one embodiment the transistor comprises a nanowire structure.

In one embodiment at least one tunnel barrier is provided with a variable width, W, such that the width can be varied by application of the applied gate voltage.

In a further embodiment of the invention there is provided a transistor adapted to provide at least one tunnel barrier, said tunnel barrier comprising a variable transparency and controlled by an electrode, such that current or electron flow in the transistor is minimised when the transistor is turned off and the current is maximized when the transistor is turned on.

There is also provided a computer program comprising program instructions for causing a computer program to carry out the above method which may be embodied on a record medium, carrier signal or read-only memory.

### Brief Description of the Drawings

The invention will be more clearly understood from the following description of an embodiment thereof, given by way of example only, with reference to the accompanying drawings, in which:-
Figure 1 illustrates 1^{st} energy sub-band along the transport direction (left) and spectrum of the current vs energy in a regular MOSFET below threshold (at Vg=-0.4V);
Figure 2 illustrates 1^{st} energy sub-band along the transport direction (left) and Spectrum of the current vs. energy in a regular MOSFET above threshold (at Vg=0);
Figure 3 is a comparison of the ID-VG curve of a 3nm x 3nm GAA 10nm channel long nanowire with and without a very high 'constant' or with negligible variation tunnel barrier;
Figure 4 shows 1^{st} energy subband along the transport direction (left) and Spectrum of the current vs.
energy in the VBT nanowire with a very high 'constant' barrier or with negligible variation of the tunnel barrier shape below threshold (Vg=-0.4V);
Figure 5 illustrates 1^{st} energy subband along the transport direction (left) and Spectrum of the current vs. energy in the VBT nanowire with a very high 'constant' barrier or with negligible variation of the tunnel barrier shape above threshold at Vg=0.0V;
Figure 6 illustrates a profile of the tunnel barrier height according to the invention;
Figure 7 illustrates a comparison of current curves and current slopes using the VBT of profile of Figure 6;
Figure 8 illustrates oscillation in the Id-Vg curve induced by a VBT barrier;
Figure 9 illustrates a "Classical" transistor, for example an SOI (silicon-on-Insulator) transistor, or a nanowire transistor;
Figure 10 illustrates a transistor with an electrically charged plane in the channel according to one aspect of the invention;
Figure 11 illustrates a transistor with an electrically charged plane in the channel according to another aspect of the invention;
Figure 12 illustrates a transistor with two constrictions near/at the edges of the channel.
Figure 13 illustrates an example of a fabrication process to produce the transistor according to the invention;
Figure 14 is a schematic view of the simulated gate-all-around (GAA) nanowire with two constrictions;
Figure 15 illustrates the barrier height vs. diameter reduction of the constriction for a reference diameter of 2 and 3 nm in a square nanowire;
Figure 16 illustrates the first subband *vs. x* profile in a 2nm × 2nm [100] GAA nanowire with two constrictions of the semiconductor cross-section for different gate voltage values;
Figure 17 Id-Vg curves of the 2nm x 2nm [100] GAA nanowire without and with 2 constrictions of the semiconductor cross-section;
Figure 18 illustrates subthreshold slope vs. Vg of a 2nm x 2nm [100] GAA nanowire with 2 constrictions of the semiconductor cross-section;
Figure 19 illustrates the evolution with Vg of the electron concentration in a classical transistor (Left) and of the 1^{st} subband *vs.* x profile in the 2nm × 2nm [100] GAA nanowire with 2 grain boundaries at the gate edge of the semiconductor cross-section; and Figure 20 illustrates Id-Vg curves of a 2nm x 2nm GAA nanowire without and with 2 grain boundaries (GB) at 1nm outside the gate edge of the semiconductor cross-section.

### Detailed Description of the Drawings

Before discussing detailed embodiments of the invention it is necessary to discuss the new principle upon which the invention operates.

The invention provides a transistor device that comprises one or more variable tunnel barrier(s). The barrier(s) varies in such a way that the transparency of the barrier is changed in a range of energies relevant to the current transport (from the minimum of the conduction band to a few tens of kT/q over the Fermi level for an N-channel transistor) when a voltage is applied to an electrode of the transistor device, for example the gate electrode. In this specification the term 'transparency' is used to define the material property of allowing electrons to pass through.

According to the invention in order to improve the on-to-off current ratio of the transistor, the transparency of the barrier, Tr, is increased, by reducing the height and/or width and/or by modifying the shape of the barrier when the gate voltage is increased when the device is in the subthreshold regime.

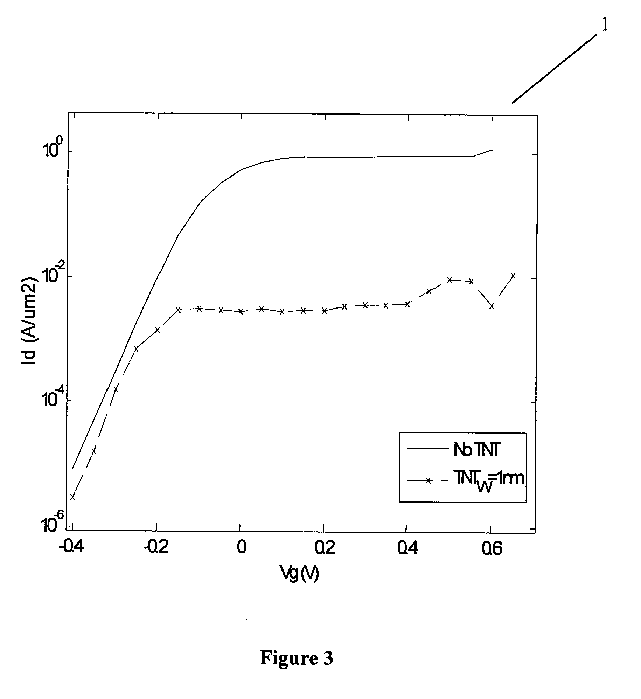

To reduce the off current of the transistor, a tunnel barrier with transparency Tr as low as possible is required. Ideally Tr=0, such that the off current is equal to zero. However, if the transparency of the barrier is not increased in the energy range of interest (i.e. if Tr is constant or increases only for energies that are so high that the concentration of free electrons is very low), the current will increase at best as an exponential function of qV_{g}/kT, and there will be no improvement of the subthreshold slope or the on-to-off current ratio. Such a case is illustrated in the example of Figures 3, 4 and 5 which describes a nanowire with a very high tunnel barrier, TB_{VBT}, of constant width next to the channel potential barrier.

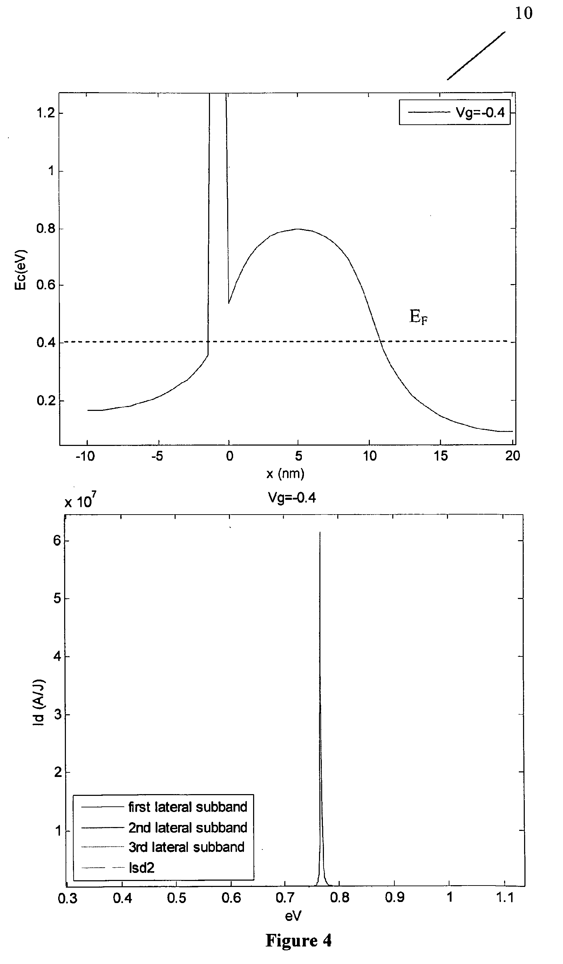

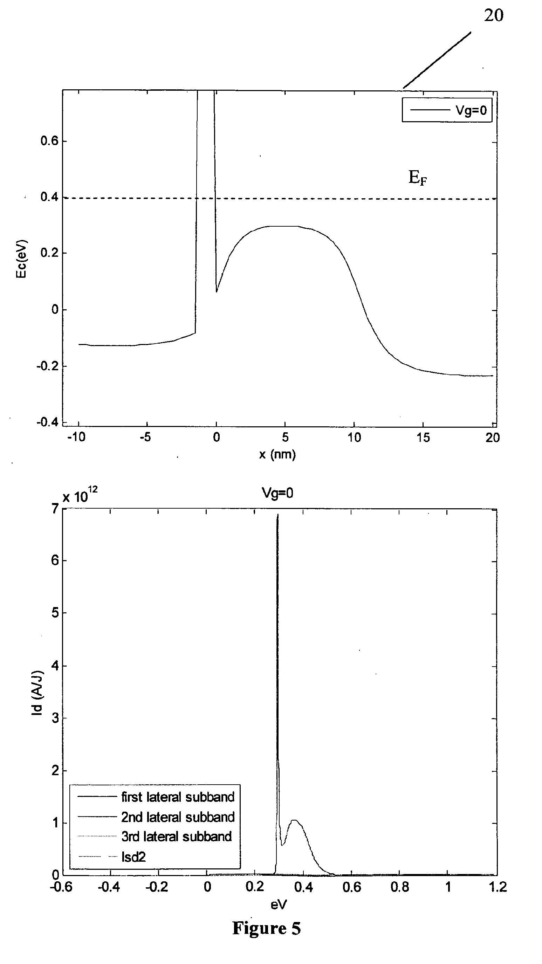

For Figures 3, 4 and 5, the height of the tunnel barrier stays much higher than both E_{F} and TB_{ch} for every Vg value. The transparency of such a TB_{VBT} in the energy range populated by the electrons remains constant for all Vg values. The behaviour is then quite similar to what is happening in a classical transistor without a TB_{VBT}. The only barrier that the electrons see reducing with Vg allowing an increase of current is the potential barrier of the channel. The only effect of the tunnel barrier is an overall reduction of the current level, as shown in Figure 3, since the electrons that could flow from the source to the drain because having an energy higher than TB_{ch}, now experience an additional barrier, TB_{VBT} (Figures 4 and 5) which reduces the current level.
Figure 3 illustrates a comparison of the ID-VG curve of a 3nm x 3nm GAA 10nm channel long nanowire with and without a V barrier, indicated by the reference numeral 1. The barrier is 3eV high (oxide) and 1nm thick. Simulations are performed assuming an isotropic effective mass me₁=0.19 me₀. Vd=0.1V. The Fermi level is 0.4eV. The threshold voltage which corresponds to the moment where the top of the energy barrier of the first sub-band in the channel passes below E_{F}, is around Vg=-0.1V.
Figure 4 illustrates the 1^{st} energy sub-band along the transport direction (left) and Spectrum of the current vs.
energy in the VBT nanowire in subthreshold regime at Vg=-0.4V. TB_{ch}, and therefore, the current density peak, is a little below 0.8eV, which is above E_{F}, indicated by the reference numeral 10.
Figure 5 illustrates the 1^{st} energy sub-band along the transport direction (left) and Spectrum of the current vs. energy in the VBT nanowire above threshold at Vg=0.0V. TB_{ch} is a little below 0.3eV, which is below E_{F}. This leads to a broad spectrum of the current density between TB_{ch} and E_{F}, indicated by the reference numeral 20.

Therefore, only a barrier that decreases in magnitude, width or shape with V_{g} will allow for a larger increase of current whith Vg than in a device without tunnel barrier(s).

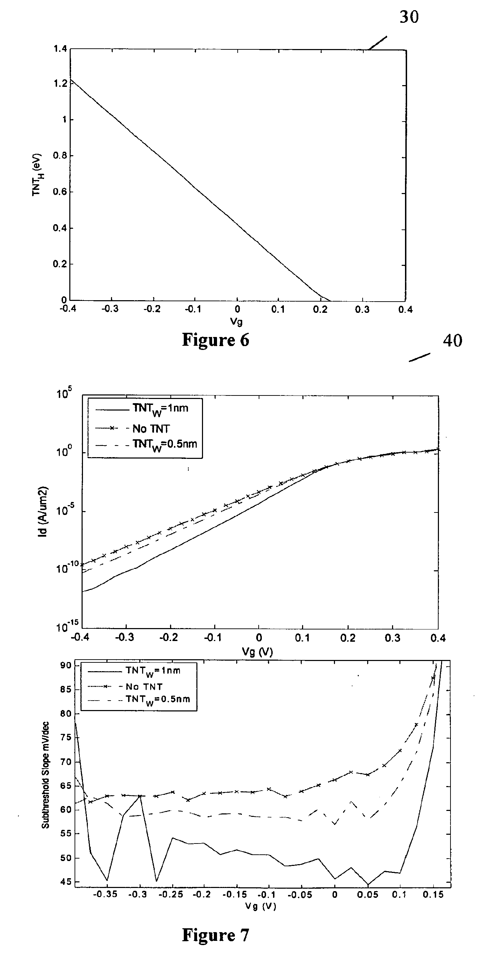

Indeed, if the tunnel barrier is lowered, i.e. if its transparency is increased, the current will increase and this with a slope that can be better than kT/q*log(10). Ideally, in order to have no reduction of the on-current, when compared to a normal transistor, the tunnel barrier must become fully transparent in the electron rich energy range around E_{F} for Vg around threshold. This would be equivalent to have the off current of the curve with a tunnel barrier AND the on current of the curve without a barrier in Figure 3. By using this principle of variable tunnel barrier it is therefore possible to improve the on-to-off current ratio. If the transparency of the tunnel barrier is increased continuously with Vg, as exemplified in Figure 6, a progressive transition is obtained between an off current that is reduced by a tunnel barrier to an on current that is not hampered by a barrier. In that case, the subthreshold slope can be improved below kT/q log(10) and the stronger the increase in transparency, the steepest the slope as shown in Figure 7.

Figure 6 illustrates the profile of the tunnel barrier height used in the simulation of Figure 5. The barrier height decreases linearly with Vg, so that to pass below E_{F} value (0.065eV) at threshold (Vg=0.2V), indicated by the reference numeral 30.

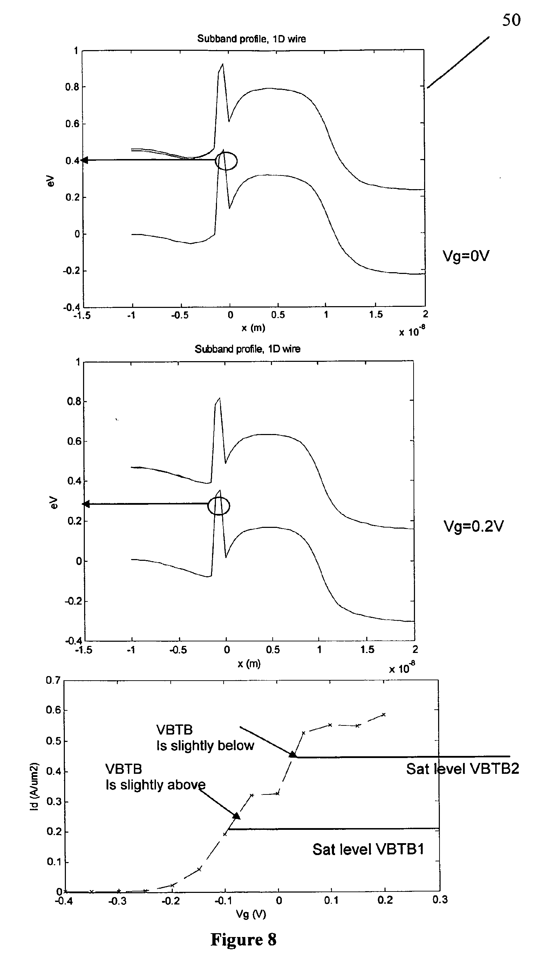

If the transparency of the tunnel barrier is increased abruptly with Vg, as exemplified in Figure 8, it is equivalent to make an abrupt transition between the off current of the curve with a tunnel barrier to the on current of the curve without a barrier in Figure 4, and an oscillation in the current is observed. The stronger the increase in the transparency the larger the oscillation observed.

Finally by reversing the principle, i.e. decreasing the transparency with Vg, it is possible to decrease the current with Vg and/or provide regions with a negative transconductance. This is useful for oscillator and some memory devices applications.
Figure 7 is a comparison of Id-Vg curves (Left) and subthreshold Slopes (Right), indicated by the reference numeral 40, of a [100] 1.5nm x 1.5nm cross-section silicon nanowire with a channel length of 5nm with a rectangular shaped VBT barrier with a height that varies with Vg as illustrated in Figure 6 and a width of 1nm and 0.5nm and the same nanowire without a VBT barrier. The 3 transistors have the same On-current but the off-current and the subthreshold slope is sensibly improved with the width of the barrier. Thanks to the barrier the subthreshold slope is better than this theoretical best value of k_{B}/T or 60mV/dec at T=300K.
Figure 8 illustrates oscillations in the Id-Vg curve induced by a VBT barrier around the Fermi level in the VBT nanowire. TB_{VBT}__{H} =0.4eV. TB_{VBT_W}=1nm, indicated by the reference numeral 50.

### Example Implementations of the VBT Barrier:

The tunnel barrier can be created by inserting any kind of local discontinuities in the device structure; for example by a local constriction, by having a thin sheet of material with a different bandgap inserted in the channel, by creating defects, by inserting a heavily doped barrier, by creating localized "trapped" surface charges by having different zone with different gates at different gate voltages, by a Schottky contact, and/or by combining two or several of these means together.

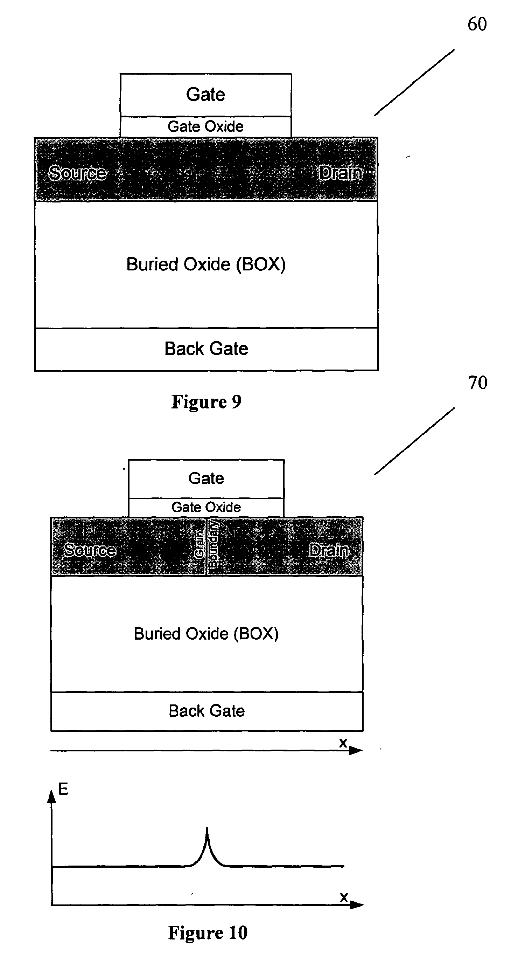

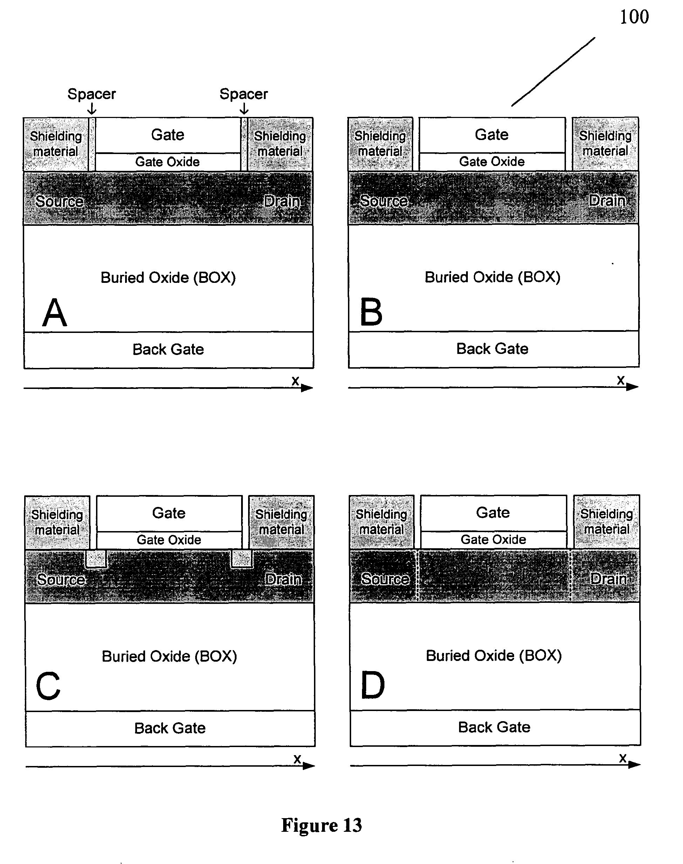

Figures 9 to 12 show a few embodiments and the resulting energy barrier shape, while Figure 13 gives an example of the fabrication process steps in order to realize these devices).

Figure 9 is a "Classical" transistor, known in the art. This represents an SOI (silicon-on-Insulator) transistor, or a nanowire transistor, indicated by the reference numeral 60.

Figure 10 illustrates a transistor with an electrically charged plane in the channel, according to the invention, indicated by the reference numeral 70. The charged plane can, for example, be a crystalline defect region such as a grain boundary or another discontinuity where electrical charges are placed by doping, trapping or other means. The bottom of the figure represents an energy barrier (tunnel barrier) created by the electrical charge.

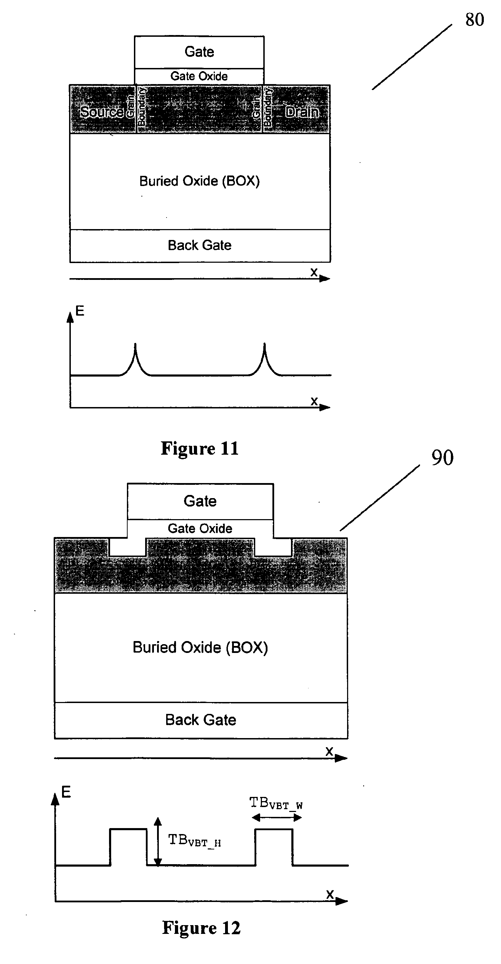

Figure 11 illustrates a transistor with an electrically charged plane in the channel, indicated by the reference numeral 80. The charged planes can, for example, be crystalline defect regions such as grain boundaries or other discontinuities where electrical charges are placed by doping, trapping or other means. The bottom of the figure represents the energy barrier (tunnel barrier) created by the electrical charge regions.

Figure 12 illustrates a transistor with two constrictions near/at the edges of the channel, indicated by the reference numeral 90. The bottom of the figure represents the energy barrier (tunnel barrier) created by the constrictions.

Figure 13A to 13D illustrates an example of fabrication process to make one device operating according to the invention, indicated by the reference numeral 100. A: Formation of an SOI transistor (or nanowire transistor) with spacers along the edges of the gate stack and sacrificial material on top of the source and drain regions. The "shielding" material can be removed after device fabrication, or be part of a source/drain stack, such as an epitaxially grown semiconductor. B: Selective removal of the spacer material. C: Growth of an oxide or silicon etch/removal in the areas where the spacers have been removed. This creates constrictions near/at the edges of the gate, in the silicon film/wire. D: Formation of defective regions such as grain boundaries by e.g. ion implantation or thermal or chemical treatment in the areas where the spacers have been removed.

The barrier transparency is related to the barrier height, TB_{VBT_H}, and width, TB_{VBT_W}. It also depends on the exact nature and physical dimensions (shape) of the discontinuity.

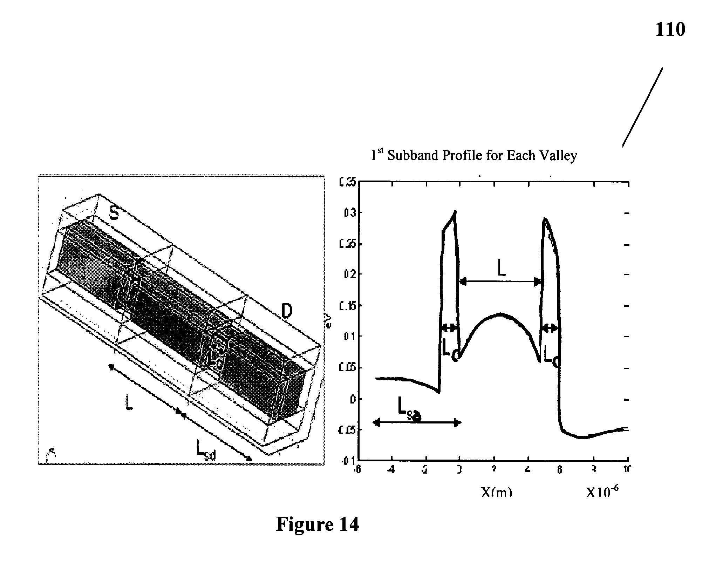

Figure 14 illustrates a schematic view of the simulated gate-all-around (GAA) nanowire with the two constrictions, indicated by the reference numeral 110, of the semiconductor cross-section at the Source extension (S)-body and body-Drain extension (D) boundaries (Left). 1^{st} subband *vs. x* in a 2nm × 2nm [100] GAA) nanowire with the 2 constrictions of the semiconductor cross-section. Δtₛᵢ=ΔWₛᵢ=0.5 nm (Right). L_{sd}=L=5nm. L_{C}=1nm. The energy barrier resulting from the constriction can clearly be observed. V_{g}=V_{d}=0.1V.

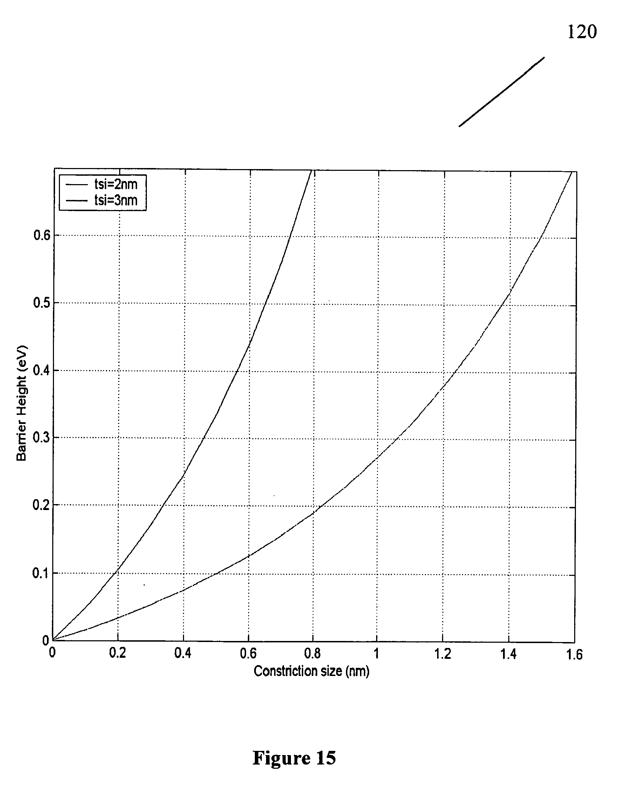

Figure 12 and 14 show that a local energy barrier can be created by reducing locally the cross-section of the nanowire. The width of the barrier TB_{VBT_W} can be tuned by modyfying the length of the constriction (L_{C}) in the x (transport) direction. The height of the barrier can be adjusted by reducing the area of the cross-section (Δtsi) as shown in Figure 15.

Figure 15 illustrates barrier Height vs. diameter reduction of the constriction for a reference diameter of 2 and 3 nm in a square nanowire, indicated by the reference numeral 120.

Using one or several constrictions it is possible to create one or several barriers. In order to change the transparency of the barrier(s), we can use a voltage change in the device. This can be applied to an additional gate, to the backgate, to the drain, or to the gate itself in the case where the gate directly controls the transparency of the barrier(s).

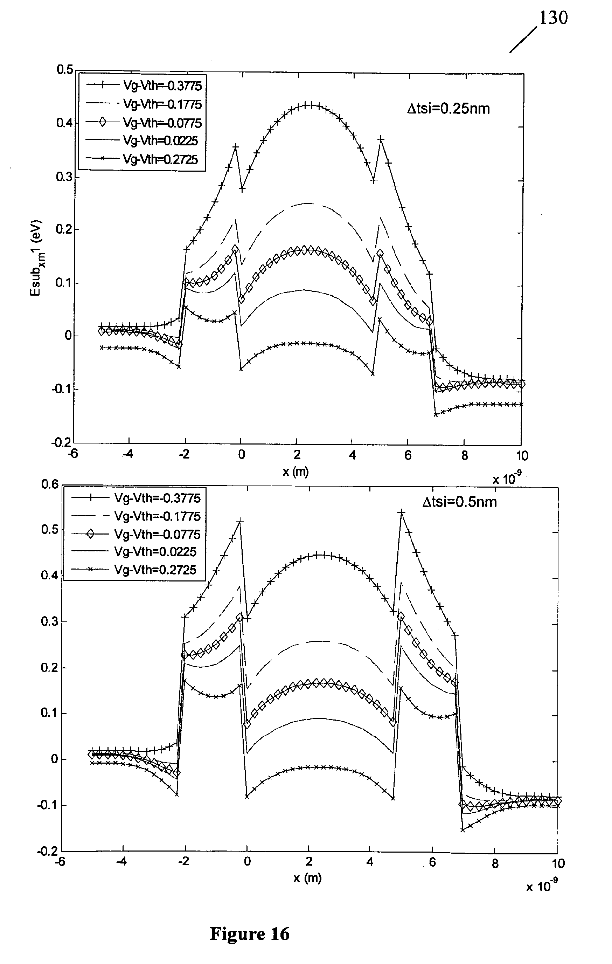

The case where the gate voltage controls the barrier(s) is illustrated in Figure 16. indicated by the reference numera1130. Figure 16 illustrates the evolution with Vg-Vₜₕ of the 1^{st} subband *vs. x* profile in the 2nm × 2nm [100] GAA nanowire with the 2 constrictions of the semiconductor cross-section. Δtₛᵢ=ΔWₛᵢ=0.25 nm (Left). Δtₛᵢ=ΔWₛᵢ=0.5nm (Right). L_{sd}=L=5nm. V_{d}=0.1V. Constriction width, L_{C}=2nm.

The electrostatics of the regions at the edge of the gate is controlled below threshold by the gate, while above threshold they are controlled by the source and drain voltages at the source and drain edges of the gate, respectively. Therefore, the energy bands at the edges of the gate are bent upwards for negative value of (Vg-Vth), i.e. below threshold, while they are pulled downwards for Vg>Vth, i.e. above threshold. By placing a constriction at one or each edge of the gate (Figure 14), this natural movement of the energy bands can be used to improve the control of the transparency of the barrier in such a way that the off current is blocked more efficiently that the on current.

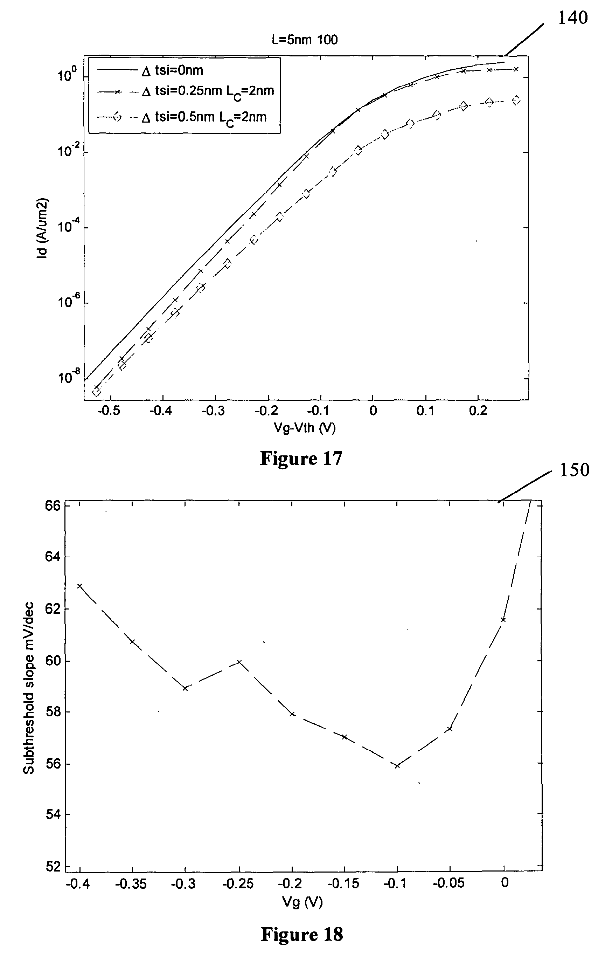

Figure 17 shows Id-Vg curves of a 2nm x 2nm [100] GAA nanowire without and with two constrictions of the semiconductor cross-section with Δtₛᵢ=ΔWₛᵢ=0.25 nm and Δtₛᵢ=ΔWₛᵢ=0.5 nm. L_{sd}=L=5nm. Vd=0.1V, indicated by the reference numeral 140.

By properly selecting the barrier height (related to the constriction size Δtsi), width and shape, the on-to-off current ratio and the subthreshold slope can be significantly improved, compared to a classical transistor as shown in Figure 17 and the subthreshold slope can be smaller than KT/q*log(10) or 59.6mV/dec at T=300K (Figure 18). The advantage can be lost by using a barrier which is too high (Δtsi=0.5nm in Figure 17). As explained before, for Δ=0.5nm, the transparency of the barrier is not increased in the energy range of interest when V_{g} is increased (Tr increases only for energies so high that there is not enough electrons to influence the current significantly Figure 16).

Figure 18 shows the subthreshold slope vs. Vg of a 2nm x 2nm [100] GAA nanowire with two constrictions of the semiconductor cross-section. T=300K, indicated by the reference numeral 150.

A barrier that decreases both in height and width with Vg can be obtained for instance by forming one or several grain boundaries in the semiconductor using polycrystalline semiconductors, or by any means that creates local defects in the crystalline structure. This creates a local surface density of negative charges and an electrostatic barrier that curves the bend upwards (Figures 10 and 11). However, as the numbers of electrons in the channel is increased for increasing gate voltage, the effect of these local defects is more and more screened by the electrons in the channel and both the barrier height and width decrease.

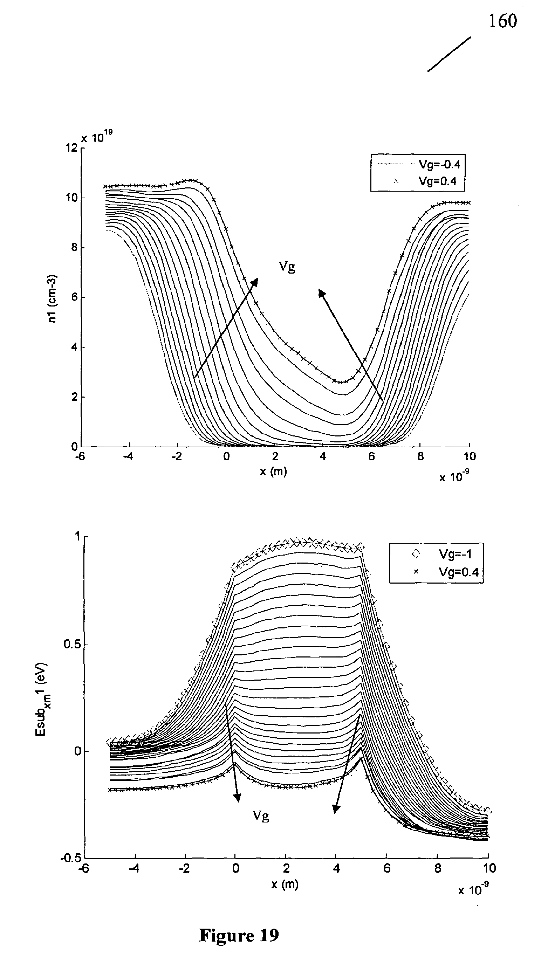

Figure 19 illustrates the evolution with Vg of the electron concentration in a classical transistor (Left) and of the 1^{st} subband *vs. x* profile in the 2nm × 2nm [100] GAA nanowire with 2 grain boundaries at the gate edge of the semiconductor cross-section. (Right). L_{sd}=L=5nm. V_{d}=0.4V, indicated by the reference numeral 160.

The electron concentration increases everywhere in the channel when Vg is increased. However, the regions at the edge of the gate constitute an effective place to put the grain boundaries because of their particular electrostatic characteristics. The regions near the boundaries are depleted by the negative gate voltage below threshold. The electron concentration is rapidly increased and reach a value comparable to that in the source and drain doping when threshold is reached, as they become controlled by the source and drain voltages at the source and drain edges of the gate respectively, wherever else in the channel the electron concentration is lower (Figure 19.Left). This allows a faster increase of the tunnel barrier transparency below threshold near the gate edge. In addition, the positive effect of the natural movement of the energy band in these regions is superimposed to the increase of the transparency of the grain boundary itself (Figure 19.Right). Therefore, by placing a grain boundary at one or each edge of the gate, one can improve the transparency of the barrier in such a way that the off current is blocked more efficiently that the on current.

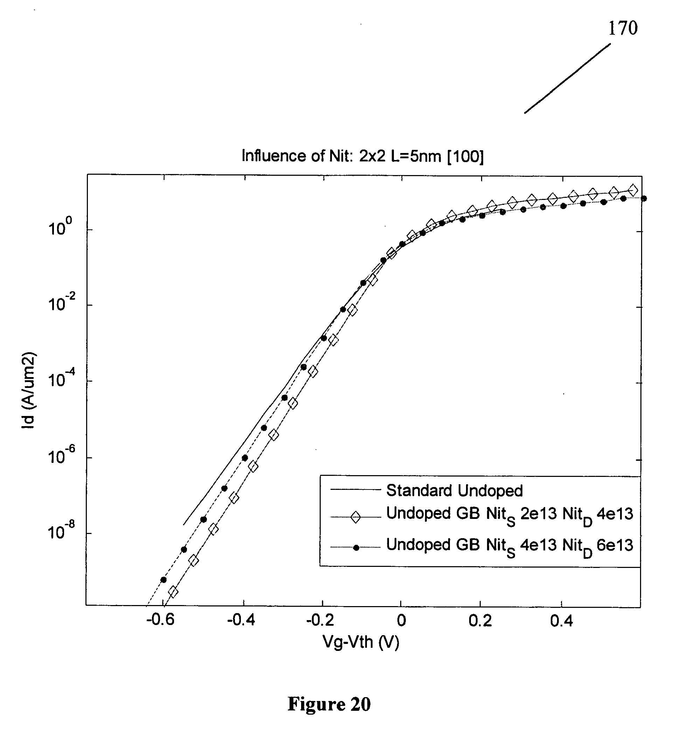

By properly selecting the barrier shape, height and width (which parameters are mainly related to the number of defect which results on a surface density of charge, -q.Nit, which can be adjusted by changing the process parameters) and position, the on-to-off current ratio and the subthreshold slope can be significantly improved compared to a classical transistor as shown in Figure 20 and the subthreshold slope can be smaller than KT/q.log(10) or 59.6mV/dec at T=300K. Additional parameters to tune the barrier properties are the exact position of the defects and the doping level in the device.

Figure 20 illustrates the Id-Vg curves of the 2nm x 2nm [100] GAA nanowire without and with 2 grain boundaries (GB) at 1nm outside the gate edge of the semiconductor cross-section with impurities concentration at the Source side Nits and at the drain side Nit_{D} as stated in the figure. L_{sd}=L=5nm. Vd=0.4V, indicated by the reference numeral 170.

As explained before, the advantage can be lost by using a barrier which is too high.

A similar behaviour can be obtained if one replaces the grain boundary barrier by one or several PN junctions which barrier height, width and shape controlled by the level of doping at the junctions (for example at the edge of the gate) or by adding an independent gate on the top of the tunnel barrier that allows one to control its height.

Two or several of these methods could also be coupled together as for example a grain boundary with a local change of section size for further optimization of the barrier behaviour vs. Vg and/or an independent gate on the top of the tunnel barrier that allows one to further control its transparency.

It will be appreciated that a barrier that varies with Vg, according to the invention, can also be created by a PN junction (for example by creating a P-type region near the gate edge in the N+ contact region of a N-channel transistor) or by adding an independent gate on the top of the tunnel barrier that allows one to control its height.

The new transistor device according to the invention has applications in ultra fast switches operating at a very low voltage and in the area of memory devices in the nanoscale.

It will be appreciated that in the context of the present invention the term "semiconductor" includes not only silicon, which is used as preferred embodiment material in the specification, but also any other semiconducting materials, such as for example germanium, Gallium Arsenide, Indium-Gallium Arsenide, III-V compounds and IV-IV alloys.

The embodiments in the invention described with reference to the drawings may comprise a computer apparatus and/or processes performed in a computer apparatus to control the transistor device according to the invention. However, the invention may also extend to computer programs, particularly computer programs stored on or in a carrier adapted to bring the transistor into practice. The program may be in the form of source code, object code, or a code intermediate source and object code, such as in partially compiled form or in any other form suitable for use in the implementation of the method according to the invention. The carrier may comprise a storage medium such as ROM, e.g. CD ROM, or magnetic recording medium, e.g. a floppy disk or hard disk. The carrier may be an electrical or optical signal which may be transmitted via an electrical or an optical cable or by radio or other means.

The invention is not limited to the embodiments hereinbefore described but may be varied in both construction and detail.

## Claims

1. A transistor adapted to provide at least one tunnel barrier, said tunnel barrier comprising a variable shape and controlled by an electrode, such that current or electron flow in the transistor is minimised when the transistor is turned off and the current is maximized when the transistor is turned on.

2. The transistor as claimed in claim 1 wherein the electrode is an applied gate voltage such that varying the gate voltage changes the shape of the tunnel barrier and controls transparency of the electron flow in the transistor.

3. The transistor as claimed in claim 2, wherein, if, the gate voltage is increased, the transparency of the tunnel barrier, Tr, is increased by reducing the height and/or width and/or by modifying the shape of the tunnel barrier.

4. The transistor as claimed in claim 3 wherein the on-to-off current ratio of the transistor is improved and the sub-threshold slope can be decreased to values below kT/q*log(10).

5. The transistor as claimed in claim 2, wherein, if the transparency of the tunnel barrier is increased with the applied gate voltage, a progressive transition between an 'off' current that is reduced by a tunnel barrier to an 'on' current that is less reduced by that barrier.

6. The transistor as claimed in claim 2, wherein, if the transparency of the tunnel barrier is increased abruptly with the gate voltage, an oscillation in the current is obtained.

7. The transistor as claimed in claim 2 wherein if the transparency of the barrier decreases with gate voltage, the gate voltage will cause the current to oscillate to provide a region of negative transconductance.

8. The transistor as claimed in any preceding claim wherein the tunnelling is from conduction band to the conduction band on the other side of the tunnel barrier to provide intraband tunnelling.

9. The transistor as claimed in any preceding claim wherein the variable tunnel barrier is provided by a grain boundary in the transistor.

10. The transistor as claimed in any preceding claim wherein the variable tunnel barrier is provided by a constriction of the semiconductor.

11. The transistor as claimed in any preceding claim wherein the variable tunnel barrier is provided by an electrically charged sheet of material in the semiconductor.

12. The transistor as claimed in any preceding claim wherein the variable tunnel barrier is provided by a localized surface charge.

13. The transistor as claimed in any preceding claim wherein the variable tunnel barrier is provided by a local variation of the semiconductor material.

14. The transistor of any preceding claim wherein local defects in the crystalline structure of the transistor creates a local surface density of negative charges and an electrostatic barrier that curves the current profile of the transistor upwards.

15. A method for producing a transistor as claimed in any of claims 1 to 22.
